# EUROPEAN PATENT APPLICATION

(11) **EP 1 750 310 A2**
(43) Date of publication of application: **07.02.2007**
(21) Application number: 05256634.6
(22) Date of filing: 26.10.2005
(51) Int. Cl.: H01L 33/00

(54) **Omni-directional reflector and light emitting diode adopting the same**

(30) Priority: 03.08.2005 US 704884 P; 26.09.2005 KR 2005089473
(71) Applicant: Samsung Electro-Mechanics Co., Ltd., Suwon-si, Gyeonggi-do (KR)
(72) Inventor: Cho, Jae-hee, Yongin-si, Gyeonggi-do (KR); Xi, Jing-qun, Rensselaer Polytechnic Institute, Troy, NY 12180-3590 (US); Kim, Jong-kyu, Rensselaer Polytechnic Institute, Troy, NY 12180-3590 (US); Park, Yong-yo 174-601 Sanghyeon Maeul Ssangyong, Yongin-si, Gyeonggi-do (KR); Sone, Cheol-soo, Dongan-gu, Anyang-si, Gyeonggi-do (KR); Schubert, E. Fred, Rensselaer Polytechnic Instit., Troy, NY 12180-3590 (US)
(74) Representative: Kyle, Diana

(57) **Abstract**

Provided are an omni-directional reflector having a transparent conductive low-index layer formed of conductive nanorods and a light emitting diode adopting the omni-directional reflector. The omni-directional reflector includes: a transparent conductive low-index layer formed of conductive nanorods; and a reflective layer formed of a metal.

## Description

The present invention relates to a conductive omni-directional reflector and a light emitting diode adopting the same, and more particularly, to a reflector having a high electro-optic characteristic and a light emitting diode adopting the same.

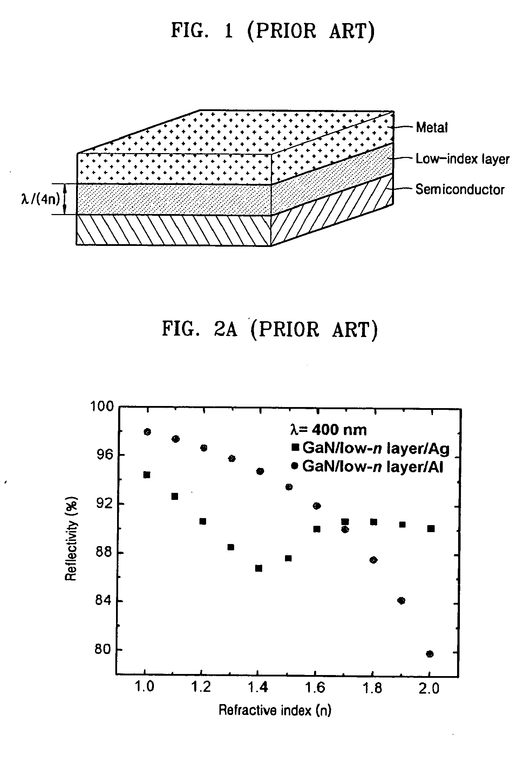

Reflectors used in LEDs must have high conductivities as well as high reflectivities. High reflective metal electrodes formed of Ag or Al have been used as existing mono metal reflectors. Such a metal reflector cannot obtain a reflectivity beyond a predetermined limit due to refractive index and extinction coefficient that is a characteristic of a metal itself. As shown in FIG. 1, an omni-directional reflector (ODR) is suggested as shown in FIG. 1 to overcome a limit of such a metal reflectivity ( Ag : about 86%, Al : about 92%). The ODR has a structure in which a low-index layer and a metal layer formed of Ag or Al are sequentially stacked on a semiconductor layer. A thickness **th** of the low-index layer must be proportional to 1/4n (**n**: refractive index) of a wavelength λ so that the ODR obtains a high reflectivity. The low-index layer is formed of a material such as SiO₂ or Si₃N₄ having a low reflectivity. The metal layer is formed of a material having a high extinction coefficient, for example, a metal such as Ag or Al. However, in the structure of the ODR, the material of which the low-index layer has been formed is generally a nonconductor. Thus, the low-index layer may not be formed of an active element injecting a current.

U.S. Pat. No.6,784,462 discloses a light emitting diode having high light extraction efficiency. A reflector is positioned between a substrate and a light emitter and includes a transparent layer formed of a low-index material such as SiO₂, Si₃N₄, MgO, or the like and a reflective layer formed of Ag, Al, or the like. The light emitting diode is characterized by which a plurality of micro-ohmic contacts are arrayed on the transparent layer of the reflector so as to inject a current. The transparent layer is formed of the low-index material such as SiO₂, Si₃N₄, MgO or the like, and the reflector is formed of Ag or Al. However, the disclosed light emitting diode uses the micro-ohmic contacts having a limited area. Thus, a contact resistance is large, and thus an operation voltage is high. Also, a process of piercing the transparent layer to a micro-size is not suitable for mass-production and requires highly elaborate patterning and etching processes.

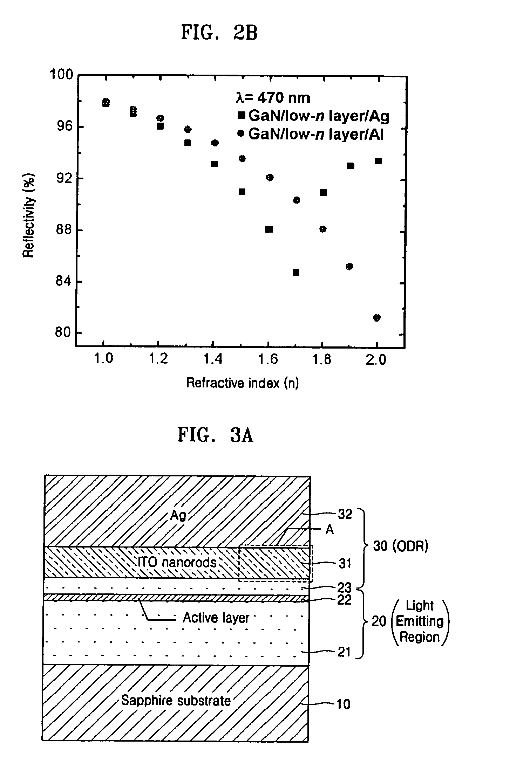

A refractive index of a low-index layer is required to be minimized to obtain a high-quality ODR because a reflectivity is increased with a low refractive index. FIGS. 2A and 2B are graphs illustrating variations in reflectivities of an Ag ODR and Al ODR with respect to a refractive index of a low-index layer. The Ag ODR includes an Ag reflector having a thickness of 2.000Å, and the Al ODR includes an Al reflector having a thickness of 2,000Å

As shown in FIGS. 2A and 2B, the reflectivity is increased with the low refractive index. The reflectivity of the Al ODR is much higher than that of the Ag ODR at a wavelength of 400nm. Thus, a high reflectivity of 92% or more can be obtained within a refractive index range between 1.1 and 1.5, the refractive index being usable in an ODR. In other words, a refractive index of a low-index layer is required to be minimized to obtain a high-quality ODR. Furthermore, transparency and conductivity are required to be high.

The present invention provides an ODR adopting a low-index layer having a high electric conductivity and a very low refractive index so as to secure a high electric characteristic and high light extraction efficiency and a light emitting diode adopting the ODR.

According to an aspect of the present invention, there is provided an omni-directional reflector including: a transparent conductive low-index layer formed of conductive nanorods; and a reflective layer formed of a metal.

According to another aspect of the present invention, there is provided a light emitting diode including: a light emitting region comprising an active layer and upper and lower semiconductor layers; a transparent conductive low-index layer comprising a plurality of conductive nanorods formed on one of the upper and lower semiconductor layers of the light emitting region; and a metal reflective layer formed on the transparent conductive low-index layer.

The plurality of conductive nanorods may be formed of a transparent conducting oxide or a transparent conducting nitride.

The transparent conducting oxide may be formed of In, Sn, or Zn oxide and selectively include a dopant. The dopant may be Ga, Cd, Mg, Be, Ag, Mo, V, Cu, Ir, Rh, Ru, W, Co, Ni, Mn, Pd, Pt, or La.

The transparent conducting nitride may include Ti and N and be formed of TiN, TiON, or InSnON.

A thickness of the transparent conductive low-index layer may be proportional to a 1/4 n (n: refractive index) of a peak wavelength of the light emitting region. The metal reflective layer may be formed of Ag, Ag₂O, Al, Zn, Ti, Rh, Mg, Pd, Ru, Pt, and Ir.

The conductive nanorodes may be formed using sputter or e-beam oblique angle deposition.

The above and other features and advantages of the present invention will become more apparent by describing in detail exemplary embodiments thereof with reference to the attached drawings in which:
FIG. 1 is a view illustrating a stack structure of a general ODR;
FIGS. 2A and 2B are graphs illustrating variations in reflectivities of ODRs with respect to variations in refractive indexes of low-index layers of the ODRs;
FIG. 3A is a schematic cross-sectional view illustrating a stack structure of a light emitting diode according to an embodiment of the present invention;
FIG. 3B is a scanning electron micrograph (SEM) of a substantial sample corresponding to portion **A** shown in FIG. 3A;
FIG. 4 is a cross-sectional view illustrating a stack structure of a conventional light emitting diode adopting a simple metal reflector;
FIG. 5A is a graph illustrating current (I)-voltage (V) characteristics of the light emitting diode of the present invention shown in FIG. 3A and the conventional light emitting diode shown in FIG. 4;
FIG. 5B is a graph illustrating light output with respect to variations in currents of the light emitting diode of the present invention shown in FIG. 3A and the conventional light emitting diode shown in FIG. 4;
FIG. 6 is an SEM of a nanorod low-index layer substantially manufactured in an ODR according to an embodiment of the present invention;
FIG. 7 is a view illustrating a method of forming a nanorod low-index layer using e-beam oblique angle deposition according to an embodiment of the present invention;
FIG. 8 is an SEM of a substantially manufactured sample showing a flux incidence angle and an oblique angle of nanorods formed using e-beam oblique angle deposition;
FIG. 9 is a graph illustrating variations in a refractive index of a low-index layer formed of SiO₂ nanorods on a silicon substrate to a thickness of 150.8nm with respect to a wavelength;
FIG. 10A is an SEM of an ITO nanorod low-index layer;
FIG. 10B is an AFM of an ITO nanorod low-index layer;
FIG. 11A is an SEM of a CIO(CulnO) nanorod low-index layer; and
FIG. 11 B is an AFM of a surface of the CIO nanorod low-index layer.

Hereinafter, an ODR and a light emitting diode adopting the ODR according to a preferred embodiment of the present invention will be described in detail with reference to the attached drawings.

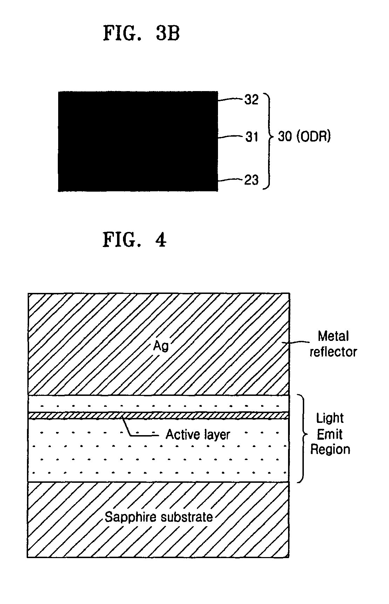

FIG. 3A is a schematic cross-sectional view of a light emitting diode having an ODR according to an embodiment of the present invention, and FIG. 3B is an SEM of a substantially manufactured ODR corresponding to portion **A** shown in FIG. 1. As shown in FIG. 3A, a light emitting region including a lower semiconductor layer 21, an active layer 22, and an upper semiconductor layer 23 is formed on a transparent sapphire substrate 10. An ODR 30 including one of the lower and upper semiconductors 21 and 23 as one component, i.e., the upper semiconductor layer 23 in the present embodiment, is formed on the light emitting region 20. As shown in FIGS. 3A and 3B, the ODR 30 includes the upper semiconductor layer 23, a low-index layer 31 formed of conductive nanorods on the upper semiconductor layer 23, a metal reflective layer 32 formed on the low-index layer 31.

The conductive nanorods may be formed of transparent conducting oxide (TCO) or transparent conducting nitride (TCN)

The TCO may be In, Sn, or Zn oxide that may selectively include a dopant. Here, a usable dopant may be Ga, Cd, Mg, Be, Ag, Mo, V, Cu, Ir, Rh, Ru, W, Co, Ni, Mn, Pd, Pt, or La.

The TCN includes Ti or/and N, that is, at least one of Ti and N, in detail, may be formed of TiN, TiON, or InSnON.

A thickness of the low-index layer 31 is proportional to 1/4n of a peak wavelength of the light emitting region 20. The metal reflective layer 32 is formed of Ag, Ag₂O, Al, Zn, Ti, Rh, Mg, Pd, Ru, Pt, Ir, or the like.

FIG. 4 is a cross-sectional view of a reference sample to be compared with the light emitting device of the present invention, i.e., a light emitting device in which an Ag reflector is directly formed on an upper semiconductor layer without a low-index layer.

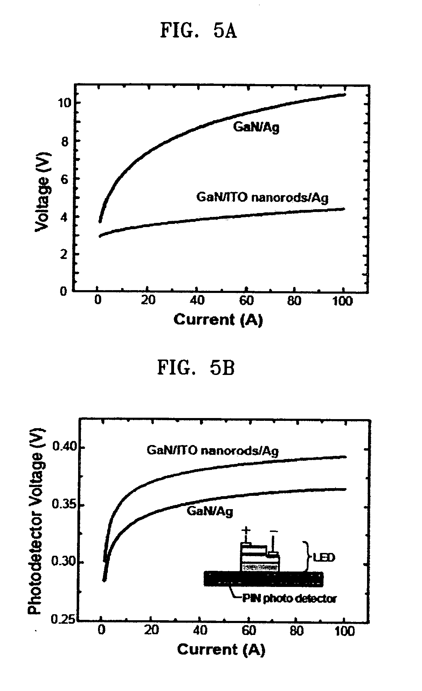

FIG. 5A is a graph illustrating I-V characteristics of the light emitting device of the present invention shown in FIG. 3A and the light emitting device shown in FIG. 4. Referring to FIG. 5A, the light emitting diode shows a very high current at a voltage relatively lower than that of the reference sample. In particular, a considerable increase of a current appears in a voltage range between 3V and 4V. However, the reference sample requires a considerably high driving voltage. In particular, the reference sample requires a higher driving voltage to obtain a high current. As shown in FIG. 5A, the light emitting diode of the present invention shows a very high current at a low voltage. Also, the voltage shows little change when compared to the current.

FIG. 5B is a graph illustrating light intensity with respect to variations in currents of the light emitting device of the present invention shown in FIG. 3A and the reference sample shown in FIG. 4, i.e., variations in output voltages of photodetectors. The results of FIG. 5B may be estimated through the results of FIG. 5A. In other words, the light emitting diode of the present invention shows a very high light intensity at the same current compared to the reference sample.

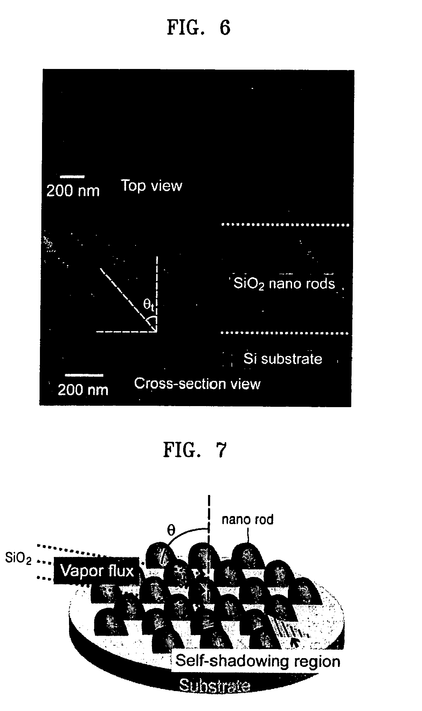

FIG. 6 is an SEM of a substantially manufactured conductive low-index layer. A lower portion of the SEM shows a cross-section of the conductive low-index layer, and an upper portion of the SEM shows a surface of the low-index layer.

The conductive low-index layer shown in FIG. 6 is SiO₂ nanorodes formed on a silicon substrate using e-beam oblique angle deposition. A SiO₂ flux is incident at an oblique angle of 85° with respect to the silicon substrate as shown in FIG. 7 so as to form the SiO₂ nanorodes. The SiO₂ nanorods are formed at an oblique angle of 45° with respect to a substrate by such oblique angle deposition. In this case, self-shadowing regions are formed. The self-shadowing regions refer to a phenomenon in which subsequently deposited materials cannot reach predetermined portions due to initially randomly deposited materials.

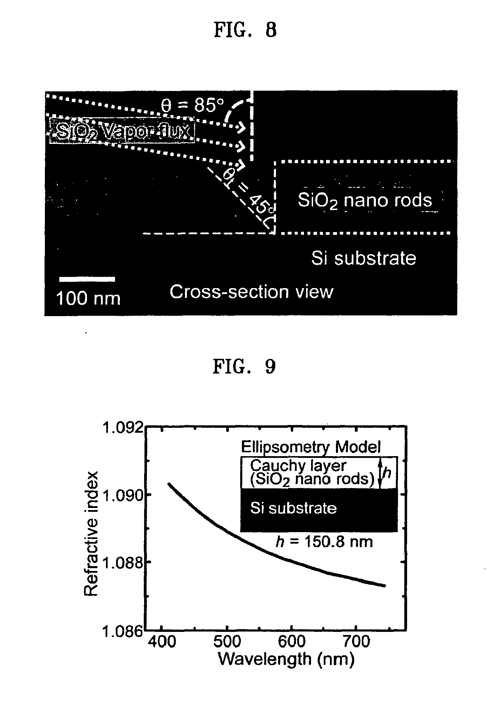

FIG. 8 is a view illustrating an incidence angle θ of the SiO₂ vapor flux and an oblique angle **θₜ** of the SiO₂ nanorods. As shown in FIG. 8, when the incidence angle of the SiO₂ vapor flux is about 85°, the oblique angle of the SiO₂ nanorods is about 45°.

FIG. 9 is a graph illustrating variations in a refractive index of a low-index layer of the SiO₂ nanorods formed on the silicon substrate to a thickness of 150.8nm with respect to a wavelength. The refractive index was measured using an ellipsometry model. Referring to FIG. 9, the refractive index is about 1.090 at a wavelength of 400nm. This is a very epoch-making result in terms of an original refractive index of SiO₂.

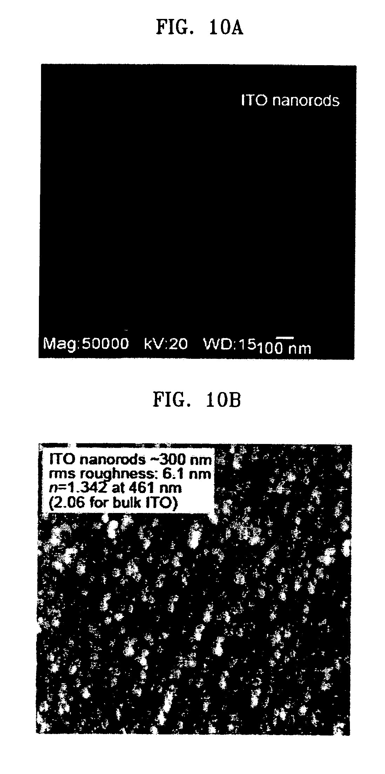

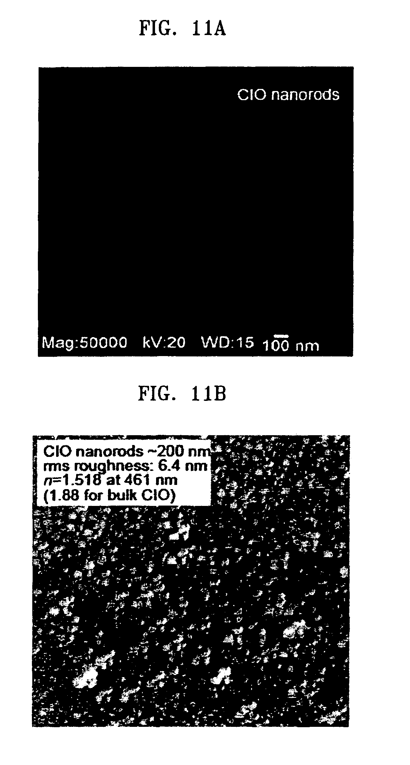

FIG. 10A is an SEM of a low-index layer formed of ITO nanorods using e-beam oblique angle deposition, and FIG. 10B is an AFM of a surface of the low-index layer shown in FIG. 10A. FIG. 11 A is an SEM of a low-index layer formed of CIO(CuInO) nanorods, and FIG. 11 B is an AFM of a surface of the low-index layer shown in FIG. 11A.

A surface roughness of the low-index layer formed of the ITO nanorods is 6.1 nm/rms (root means square), and a surface roughness of the low-index layer formed of the CIO nanorods is 6.4nm/rms.

A refractive index of the low-index layer formed of the ITO nanorods is 1.34 at a wavelength of 461 nm, and a refractive index of the low-index layer formed of the CIO nanorods is 1.52 at the wavelength of 461 nm. The low refractive indexes of the low-index layers are epoch-making results in terms of respective refractive indexes "2.05" and "1.88" of ITO and CIO thin films. A low-index layer formed of ITO or CIO nanorods using e-beam oblique angle deposition has a very low refractive index and a very high electric conductivity. Thus, the low-index layer formed of the ITO or CIO nanorods may be effectively used as a low-index layer of an ODR without an additional conductor such microcontact layers.

As described above, an ODR according to the present invention has high conductivity and reflectivity. As a result, a light emitting diode having higher luminance and light extraction efficiency than a conventional light emitting diode can be obtained. The light emitting diode of the present invention does not require an additional element such as microcontacts for an additional conductive path. Thus, the light emitting diode can be easily manufactured and be economical.

## Claims

1. An omni-directional reflector comprising:
a transparent conductive low-index layer formed of conductive nanorods; and
a reflective layer formed of a metal.

2. The omni-directional reflector according to claim 1, wherein the conductive nanorods are formed of one of a transparent conducting oxide and a transparent conducting nitride.

3. The omni-directional reflector according to claim 2, wherein the transparent conducting nitride comprises at least one of Ti and N.

4. The omni-directional reflector according to claim 3, wherein the transparent conducting nitride is formed of one of TiN, TiON, and InSnON.

5. The omni-directional reflector according to claim 2, wherein the transparent conducting oxide is formed of one of In, Sn, and Zn oxides.

6. The omni-directional reflector according to claim 2 or 5, wherein the transparent conducting oxide comprises a dopant.

7. The omni-directional reflector according to claim 6, wherein the dopant is one of Ga, Cd, Mg, Be, Ag, Mo, V, Cu, Ir, Rh, Ru, W, Co, Ni, Mn, Pd, Pt, and La.

8. The omni-directional reflector according to claim 1, wherein the transparent conducting oxide is formed of one of In, Sn, and Zn oxides and comprises one of Ga, Cd, Mg, Be, Ag, Mo, V, Cu, Ir, Rh, Ru, W, Co, Ni, Mn, Pd, Pt, and La as a dopant.

9. The omni-directional reflector according to any one of claims 1 through 8, wherein a thickness of the transparent conductive low-index layer is proportional to a 1/4n of peak wavelength of light.

10. The omni-directional reflector according to any of claims 1 to 9, wherein the reflective layer is formed of one of Ag, Ag₂O, Al, Zn, Ti, Rh, Mg, Pd, Ru, Pt, and Ir.

11. The omni-directional reflector according to any of claims 1 to 10, wherein the conductive nanorods are formed using one of sputter and e-beam oblique angle deposition.

12. A light emitting diode comprising:
a light emitting region comprising an active layer and upper and lower carrier confinement semiconductor layers;
a transparent conductive low-index layer comprising a plurality of conductive nanorods formed on one of the upper and lower semiconductor layers of the light emitting region; and
a metal reflective layer formed on the transparent conductive low-index layer.

13. The light emitting diode according to claim 12, wherein the plurality of conductive nanorods are formed of one of a transparent conducting oxide and a transparent conducting nitride.

14. The light emitting diode according to claim 13, wherein the transparent conducting nitride comprises at least one of Ti and N.

15. The light emitting diode according to claim 14, wherein the transparent conducting nitride is formed of one of TiN, TiON, and InSnON.

16. The light emitting diode according to any of claims 13 to 15, wherein the transparent conducting oxide is formed of one of In, Sn, and Zn oxides.

17. The light emitting diode according to any of claims 13 to 16, wherein the transparent conducting oxide comprises a dopant.

18. The light emitting diode according to claim 17, wherein the dopant is one of Ga, Cd, Mg, Be, Ag, Mo, V, Cu, Ir, Rh, Ru, W, Co, Ni, Mn, Pd, Pt, and La.

19. The light emitting diode according to claim 13, wherein the transparent conducting oxide is formed of one of In, Sn, and Zn oxides and comprises one of Ga, Cd, Mg, Be, Ag, Mo, V, Cu, Ir, Rh, Ru, W, Co, Ni, Mn, Pd, Pt, and La as a dopant.

20. The light emitting diode according to any one of claims 12 through 19, wherein a thickness of the transparent conductive low-index layer is proportional to a 1/4n of peak wavelength of light.

21. The light emitting diode according to any of claims 12 to 20, wherein the metal reflective layer is formed of one of Ag, Ag₂O, Al, Zn, Ti, Rh, Mg, Pd, Ru, Pt, and Ir.

22. The light emitting diode according to any of claims 12 to 21, wherein the conductive nanorodes are formed using one of sputter and e-beam oblique angle deposition.
